# EUROPEAN PATENT APPLICATION

(11) **EP 2 312 642 A1**
(43) Date of publication of application: **20.04.2011**
(21) Application number: 09804951.3
(22) Date of filing: 03.08.2009
(51) Int. Cl.: H01L 31/0236, H01B 5/14

(54) **TRANSPARENT CONDUCTIVE FILM SUBSTRATE AND SOLAR CELL USING THE SUBSTRATE**

(30) Priority: 05.08.2008 JP 2008201858
(71) Applicant: Asahi Glass Company Limited, Chiyoda-ku Tokyo 100-8405 (JP)
(72) Inventor: HIGASHI, Seiji, Tokyo 100-8405 (JP); OYAMA, Takuji, Tokyo 100-8405 (JP)
(74) Representative: Müller-Boré & Partner Patentanwälte
(86) International application number: PCT/JP2009/063765
(87) International publication number: WO 2010/016468

(57) **Abstract**

To provide a transparent conductive film substrate, which is less likely to lead to a leak of an electric current by the concentration of an electric field, and which is less likely to lead to deterioration of the photoelectric conversion performance, when applied to a photoelectric conversion device such as a solar cell, and which further has a high light transmittance, and a solar cell using this substrate.

A transparent conductive film substrate for a photoelectric conversion device, comprising a first oxide structural layer, a second oxide layer and a conductive oxide layer formed in this order on a glass substrate, wherein on the first oxide structural layer, a plurality of ridges protruding from the surface of the glass substrate are provided, and the height of the ridges from the surface of the glass substrate is at least 200 nm and at most 2,000 nm; and where the average value of angles of dent portions such that the depth of a dent between adjacent ridges among the plurality of the ridges is at least 20% of the average height of the first oxide structural layer, is A₁, and the average value of angles of dent portions of the second oxide layer formed on a region on the dent portions, is A₂, A₂/A1 is at least 1.1.

## Description

### TECHNICAL FIELD

The present invention relates to a transparent conductive film substrate useful for a photoelectric conversion device such as a thin-film solar cell, and a solar cell using the substrate.

### BACKGROUND ART

A transparent conductive thin film has been used in various fields such as solar cell substrates, display substrates and touch panel substrates. Among such applications, for a photoelectric conversion device such as a thin-film solar cell, high transparency, light-trapping property, electrical conductivity, chemical durability and the like are required, and as a film which meets such requirements, a thin oxide film is widely used. In a case where a tin oxide film is used as a transparent conductive film for a solar cell, it is known from Patent Document 1 that in order to increase the light-trapping property, it is effective to increase the crystallinity of tin oxide thereby to increase the surface haze. Particularly, as disclosed in Patent Document 2, in order to effectively trap long wavelength light to short wavelength light, it is effective to form a layer comprising large crystal grains and small crystal grains in combination.

However, the above tin oxide is characterized to have steep crystal edges, and if the crystal grain size is increased, steep and sharp irregularities are formed between the crystal grains. If a solar cell is prepared by using a substrate having such steep and sharp irregularities, defects are likely to be formed in a power generation layer at a dent portion as disclosed in Patent Document 3, and on ridges, a portion is likely to be formed where a leak of an electric current is likely to occur by the concentration of an electric field, and as a result, the photoelectric conversion will be deteriorated. In order to realize a high light-trapping performance of a photoelectric conversion device, it is effective to use a substrate with a high haze, but in the substrate with a high haze, the crystal grains of tin oxide tend to be large, whereby the photoelectric conversion efficiency will hardly increase from the above reasons. The above Patent Document 2 discloses in its Examples effectiveness of the light-trapping property with respect to substrates with hazes up to 75%.

To overcome this problem, Patent Document 3 proposes processing to round the surface crystals of a transparent conductive film substrate by chemical etching or plasma treatment. Further, Patent Document 4 discloses a method of rounding the crystals on the surface of a transparent conductive film by polishing. However, in chemical etching, a process of immersing the substrate in a chemical solution of a strong acid or a strong alkali, and then rinsing it with water is required, whereby the production process is complicated, thus leading to an increase in the cost. Further, defects may be formed on the conductive film by the treatment with a chemical solution and as a result, the electrical resistance of the conductive film will be increased. Further, the sputtering treatment leads to an increase in the production cost since a vacuum process is required. Likewise, the process by polishing requires two steps of polishing and washing, thus leading to an increase in the cost. In addition, all the methods employ a process of grinding a once prepared conductive film, and are not an effective process to increase the crystal grains to increase the haze thereby to increase the light-trapping property.

### PRIOR ART

### PATENT DOCUMENTS

Patent Document 1: JP-A-2-503615
Patent Document 2: JP-A-2005-347490
Patent Document 3: JP-A-2000-277763
Patent Document 4: JP-A-2006-5021

### DISCLOSURE OF THE INVENTION

### OBJECT TO BE ACCOMPLISHED BY THE INVENTION

Under these circumstances, considering the above-described problems, it is an object of the present invention to provide a transparent conductive film substrate which is less likely to lead to a leak of an electric current by the concentration of an electric field, which is free from deterioration of the photoelectric conversion performance, when applied to a photoelectric conversion device such as a solar cell, and which further has a high light transmittance, and a solar cell using such a substrate.

### MEANS TO ACCOMPLISH THE OBJECT

The present invention provides a transparent conductive film substrate for a photoelectric conversion device, comprising a first oxide structural layer, a second oxide layer and a conductive oxide layer formed in this order on a glass substrate, wherein on the first oxide structural layer, a plurality of ridges protruding from the surface of the glass substrate are provided, and the height of the ridges from the surface of the glass substrate is at least 200 nm and at most 2,000 nm; and where the average value of angles of dent portions such that the depth of a dent between adjacent ridges among the plurality of the ridges is at least 20% of the average height of the first oxide structural layer, is A₁, and the average value of angles of dent portions of the second oxide layer formed on a region on the dent portions, is A₂, A₂/A₁ is at least 1.1.

The above A₂/A₁ is preferably at least 1.2.

Further, it is preferred that the haze measured by illuminant C is at least 50%. It is more preferred that the haze measured by illuminant C is at least 85%.

Further, it is preferred that the first oxide structural layer comprises tin oxide.

Further, it is preferred that the second oxide layer is formed by an oxide layer having a refractive index of from 1.58 to 1.9.

It is preferred that the second oxide layer comprises a mixed oxide of silicon and tin or a mixed oxide of silicon and titanium.

Further, it is preferred that the second oxide layer comprises a mixed oxide of silicon and tin, and the molar ratio of tin to silicon of the mixed oxide is from 0.25:0.75 to 0.7:0.3.

Further, it is preferred that the molar ratio of tin to silicon of the mixed oxide is from 0.4:0.6 to 0.6:0.4.

Further, it is preferred that the conductive oxide layer comprises tin oxide containing fluorine.

Further, the present invention provides a solar cell prepared by using the above transparent conductive film substrate.

### EFFECTS OF THE INVENTION

In the transparent conductive film substrate of the present invention, A₂/A₁ is at least 1.1. Accordingly, even with a roughness structure having a high haze with a high light-trapping property, the shape of the second oxide layer can be made gentle regardless of the shape of the roughness portion of the first oxide structural layer. Accordingly, in a photoelectric conversion device having a solar cell layer laminated on the transparent conductive film substrate after lamination of a transparent conductive film, a leak of an electric current by the concentration of an electric field is less likely to occur. Thus, such a photoelectric conversion device is free from deterioration of its performance resulting from the roughness. Further, as compared with a case where the thickness of the second oxide layer is the same as in conventional technology, the light transmittance of the transparent conductive film substrate is also high. Accordingly, when a solar cell is prepared by using the transparent conductive film substrate of the present invention, the performance of photoelectric conversion can be improved as compared with conventional technology.

### BRIEF DESCRIPTION OF THE DRAWINGS

Fig. 1 is a drawing schematically illustrating one example of the cross-section of the transparent conductive film substrate of the present invention.
Fig. 2 is a drawing illustrating the angle of a dent portion of the second oxide layer in the transparent conductive film substrate of the present invention.
Fig. 3 is a drawing illustrating the depth of a dent in the transparent conductive film substrate of the present invention.
Fig. 4 is a drawing illustrating the relation between the ratio (A₂/A₁) of angles employed in the present invention and the photoelectric conversion efficiency of a solar cell.
Fig. 5 is an electron microscopic photograph showing the cross-section of the transparent conductive film substrate of the present invention.
Fig. 6 is an electron microscopic photograph of the cross-section of a conventional transparent conductive film substrate.
Fig. 7 is an electron microscopic photograph showing the surface of the transparent conductive film substrate of the present invention.

### BEST MODE FOR CARRYING OUT THE INVENTION

Now, the transparent conductive film substrate of the present invention will be described below.

To prepare a substrate having a high light-trapping property, to be used for a photoelectric conversion device such as a solar cell, a first oxide structural layer is formed on a glass substrate, a second oxide layer in the form of a film is formed thereon, and a conductive oxide layer is further formed thereon. The first oxide structural layer has such a shape that it is discretely disposed on the substrate. The height of each island structure of the first oxide structural layer is at least 200 nm and at most 2,000 nm. If it is less than 200 nm, no effective long wavelength light-trapping property will be obtained, and if it exceeds 2,000 nm, the light absorption by the island structures tends to be significant. Further, it is preferably at least 300 nm and at most 1,000 nm. The first oxide structural layer can be prepared by a CVD (chemical vapor deposition) method, a nanoimprinting method, a photolithography process or the like, and in view of the production cost and easiness of large area film formation, a CVD method is preferably employed.

The substrate with a conductive oxide film disclosed in the above Patent Document 2 has such a structure that an oxide structure having a first oxide comprising crystals having large particle sizes discretely dispersed is provided on a glass substrate, a continuous layer comprising a second oxide which functions as a conductive film is formed thereon, and as the case requires, a layer comprising an oxide differing in the composition with the first oxide and the second oxide is provided between the first oxide and the second oxide. The present invention is different from the substrate disclosed in the above Patent Document 2 in that A₂/A₁ is defined as described hereinafter.

The oxide of the first oxide structural layer may, for example, be tin oxide, titanium oxide, zinc oxide, aluminum oxide or silica. Among them, tin oxide, silica or aluminum oxide is preferably used. In such a first oxide structural layer, it is preferred that the island structures of the oxide are large, thus increasing the density of the island structures, from the viewpoint of the light-trapping property. Under such preferred conditions, a steep roughness structure is formed among the island structures. By forming the second oxide layer on the first oxide structural layer having such a steep roughness shape, it is possible that the steep roughness shape becomes gentle, and the deterioration of the performance of the photoelectric conversion device such as a solar cell can be suppressed while maintaining a high light-trapping property. When the steep roughness shape of the first oxide structural layer is made a gentle roughness shape by the second oxide layer, the steep roughness shape and the gentle roughness shape can be measured by cutting the prepared transparent conductive film substrate and observing the cross-sectional shape with an electron microscope. Here, with respect to the relation between the island structures and the roughness shape, at a portion where only one nonadjacent island structure is present, the island structure itself corresponds to a ridge, and the height of the island structure is the same as the height of the ridge, and there is no dent portion at such a portion where only one island structure is present. In a case where island structures are adjacent to each other, there is a dent portion present therebetween. In such a case, the height of the ridge is the height from the dent portion to the protruded part, and does not necessarily agree with the height of the island structure.

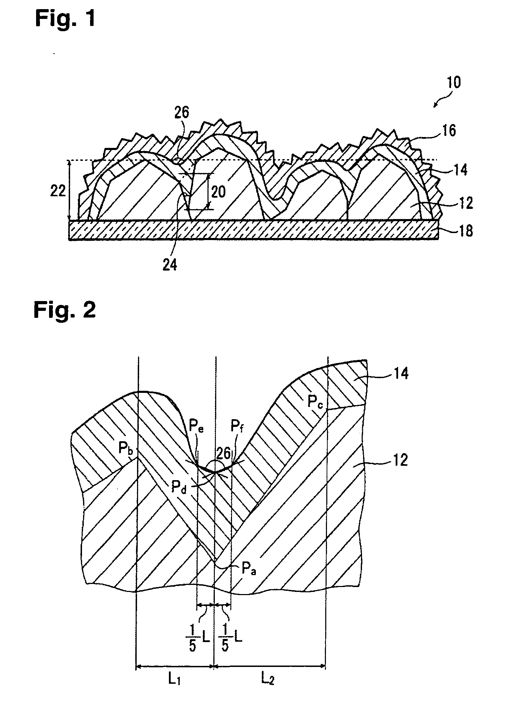

Fig. 1 is a drawing schematically illustrating one example of the cross-section of such a transparent conductive film substrate (hereinafter referred to as a transparent conductive film substrate). In Fig. 1, the height is emphasized.

A transparent conductive film substrate 10 shown in Fig. 1 comprises a first oxide structural layer 12, a second oxide layer 14 and a conductive oxide layer 16 formed in this order on a glass substrate 18.

The first oxide structural layer 12 is a layer having the above-described island structures, and having a plurality of ridges discretely provided to form dent portions among the adjacent ridges (hereinafter simply referred to as dent portions of the first oxide structural layer 12). As observed in a cross-section, one ridge has a shape constituted by a plurality of approximately straight lines, and a plurality of such ridges are adjacent to one another to constitute a steep roughness structure.

Here, the average height 22 of the first oxide structural layer 12 is defined as follows. The cross-section of the transparent conductive film is observed, the heights of 10 ridges discretely disposed in the island-form are measured, and the sum is divided by the number of the ridges to obtain the average height 22.

Further, the angle 24 of the dent portion of the first oxide structural layer 12 is defined as follows. It is the angle of the dent portion constituted by approximately straight lines, when the cross-section of the transparent conductive film is observed, and the average value is an average value of such angles at 10 points measured.

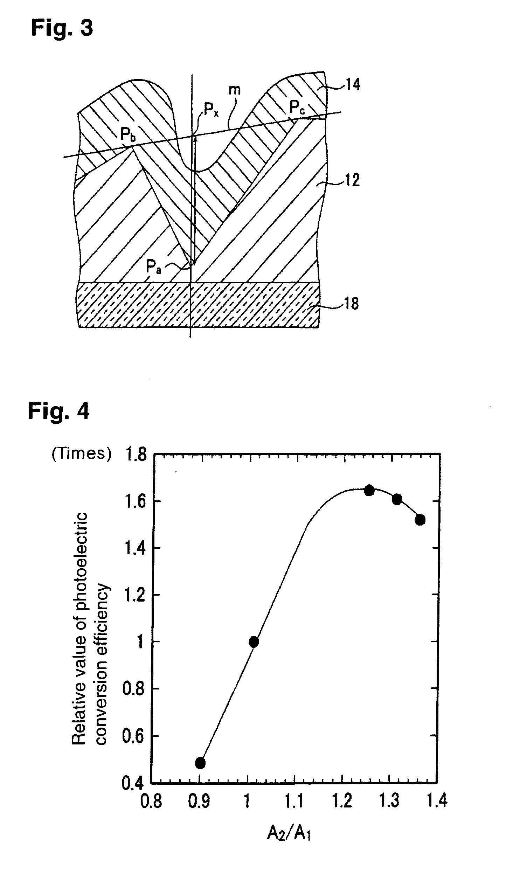

Further, the depth 20 of the dent of the first oxide structural layer 12 is defined as follows. When the cross-section of the transparent conductive film is observed as shown in Fig. 3, it is the height from Pₐ to Pₓ (the height of the arrow portion in Fig. 3), where Pₐ is the bottom of the dent portion constituted by approximately straight lines, and Pₓ is such a point that P_{b} and P_{c} (hereinafter referred to as edges P_{b} and P_{c}), each being an intersection with another approximately straight line, at the opposite end of the approximately straight line constituting the dent portion, are connected with a line m, a vertical line to the surface of the glass substrate 18 is drawn from the bottom Pₐ of the dent portion, and the intersection of this vertical line and the line m between the edges is Pₓ.

The second oxide layer 14 has the following function relative to the shape of the first oxide structural layer 12. That is, where the average value of angles 24 of dent portions such that the depth 20 of the dent portion of the first oxide structural layer 12 is at least 20% of the average height 22 of the first oxide structural layer 12 is A₁, and the average value of angles 26 (described hereinafter in detail) of dent portions of the second oxide layer 14 formed on a region on the dent portions is A₂, A₂/A₁ is at least 1.1.

The angle 26 of the dent portion of the second oxide layer 14 is defined as follows.

When a cross-section of the transparent conductive film is observed as shown in Fig. 2, where the lowest position of the first oxide structural layer 12 is Pₐ, the left and right edge positions of a dent portion are respectively P_{b} and P_{c}, and the lowest position of a dent portion of the second oxide layer 14 is P_{d}, a segment PₐP_{d} is regarded as a center line of the dent portion. Straight lines in parallel with the above center line are drawn respectively through the points P_{b} and P_{c}, and the distances between the straight lines and the center line are regarded as L₁ and L₂, respectively. A distance which is not longer between the distances L₁ and L₂ is regarded as L. Straight lines in parallel with the center line are drawn through positions at a distance of one fifth of L from the center line, and the intersections of such straight lines and the line (edge line) of the surface of the second oxide layer 14 are regarded as Pₑ and P_{f}. The angle between the segment PₑP_{d} and the segment P_{d}P_{f} is defined as the angle 26 of the dent portion of the second oxide layer 14.

When A₂/A₁ is at least 1.1, on the steep roughness shape of the first oxide structural layer 12, a gentle second oxide layer 14 constituted by a curve is formed. When a solar cell is prepared by using a transparent conductive film substrate comprising such a structure and a transparent conductive film further formed on such a structure, an improvement in the cell properties will be obtained. When A₂/A₁ is at least 1.2, the roughness shape of the second oxide layer 14 will be more gentle, and a further improvement in photoelectric conversion will be obtained. Such a second oxide layer 14 preferably has a thickness of from 20 nm to 200 nm, more preferably from 50 nm to 100 nm.

The second oxide layer 14 can be prepared by a CVD method, a sputtering method, a sol-gel method or the like, and in view of easiness of control of the film thickness, covering properties, etc., it is preferably prepared by a CVD method.

The second oxide layer 14 is preferably made of a material having a refractive index intermediate between the refractive index of the glass substrate 18 and the refractive index of the conductive oxide layer 16. By using a material having an intermediate refractive index, the transmittance will not be decreased even when the thickness of the second oxide layer 14 is at a level of from 20 nm to 200 nm. The d-line refractive index of the second oxide layer 14 is preferably from 1.58 to 1.9, more preferably from 1.6 to 1.8.

The effect of improving the photoelectric conversion when the transparent conductive film substrate of the present invention is used is excellent when the haze as measured by illuminant C in a state where layers are laminated up to the conductive oxide layer 16, is at least 50%, the effect is more remarkable when it is at least 85%, and is further remarkable with a transparent conductive film substrate with a haze of at least 90%.

The material forming the second oxide layer 14 is not particularly limited so long as it is a material having good covering property over the first oxide structural layer 12, a material having a refractive index of from 1.58 to 1.9 is particularly preferred, and a mixed oxide of aluminum (Al) and tin (Sn), a mixed oxide of silicon (Si) and tin (Sn) or a mixed oxide of silicon and titanium (Ti) may, for example, be used. The second oxide layer 14 is particularly preferably made of a mixed oxide of silicon and tin or a mixed oxide of silicon and titanium, whereby the second oxide layer 14 is easily prepared and is likely to be an amorphous film, and a favorable covering property over the first oxide structural layer 12 will be obtained. It is more preferred that a mixed oxide of silicon and tin is used for the second oxide layer 14 and that the conductive oxide layer 16 or the first oxide structural layer 12 contains the same tin component as tin oxide, whereby defects which lead to deterioration of electrical conductivity are less likely to occur at the time of film formation by crystal growth of the conductive oxide layer 16. The material of the second oxide layer 14 is more preferably such that a formed film becomes an amorphous film.

In a case where a mixed oxide of silicon and tin is used for the second oxide layer 14, when the compositional ratio of the metal elements of the oxide to be formed is represented by the molar ratio, the molar ratio of tin to silicon is preferably from 0.25:0.75 to 0.7:0.3. If the molar ratio of tin is lower than 0.2, the d-line refractive index will be lower than 1.58. If the d-line refractive index is lower than 1.58, reflection caused by the refractive index difference between the conductive oxide layer 16 and the second oxide layer 14 will be significant, whereby the light transmittance will be reduced. Further, if the molar ratio of tin is higher than 0.7, the second oxide layer 14 will not be a favorable amorphous layer of a mixed oxide, and the effect of making the roughness shape gentle will no longer be obtained. The molar ratio of tin to silicon is more preferably from 0.4:0.6 to 0.6:0.4.

The second oxide layer 14 can be prepared by a CVD method, a sputtering method, a sol-gel method or the like, and considering the production cost and the easiness to achieve a low resistance of the surface conductive layer, it is preferably prepared by a CVD method. In a case where the second oxide layer 14 is formed by a CVD method, as the silicon material, an inorganic or organic silane compound such as monosilane, monochlorosilane, dichlorosilane, trichlorosilane, tetrachlorosilane or tetraethoxysilane may be used. Among them, a chlorosilane such as tetrachlorosilane, trichlorosilane or dichlorosilane is preferred, since it will not undergo reaction in a gaseous phase in a chamber due to too fast reaction like monosilane, and thus is free from generation of a powdery reaction product, and it is easily handled since it is low explosive.

For the conductive oxide layer 16, tin oxide, zinc oxide or tin-doped indium oxide (ITO) may, for example, be used, and tin oxide is preferred in view of the chemical durability and the production cost. As tin oxide, one doped with fluorine to increase the electrical conductivity is more preferred. The conductive oxide layer 16 can be prepared by a CVD method, a sputtering method, a sol-gel method or the like, and considering the production cost and the easiness to achieve the low resistance of the surface conductive layer, it is preferably prepared by a CVD method.

Further, in a case where the glass substrate to be used in the present invention is made of soda lime glass, an alkali barrier layer may be provided between the glass substrate and the transparent conductive film so as to prevent the alkali component in glass from diffusing to the transparent conductive film side. The alkali barrier layer is preferably a silica (SiO₂) layer.

The transparent conductive film substrate provided by the present invention is useful as a substrate of a thin-film solar cell, and is particularly useful as a substrate for a tandem silicon solar cell comprising amorphous silicon and microcrystalline silicon prepared on one substrate.

### EXAMPLES

Now, the effects of the transparent conductive film substrate of the present invention will be described with reference to a transparent conductive film substrate prepared by using a CVD method as an example . However, it should be understood that the transparent conductive film substrate of the present invention is not limited thereto.

### EXAMPLE 1

### (a) Formation of first oxide structural layer

Using a soda lime glass substrate having a thickness of 1.1 mm as a glass substrate 18 (10 cm square), and on this glass substrate 18, a silica film as an alkali barrier layer was prepared. Formation of the silica film was carried out in such a manner that the soda lime glass substrate was heated at 500°C in a belt conveyer furnace, and the glass substrate was simultaneously sprayed with a nitrogen gas containing 5 mol% of a silane gas at a rate of 4 liter/min and an oxygen gas at a rate of 20 liter/min.

Then, on this glass substrate with a silica film, a first oxide structural layer 12 was formed. Here, as a method of forming the first oxide structural layer 12, a two-stage method was employed wherein centers to be the bases of dent portions were formed first, and then ridges were produced changing the production conditions. For formation of the first oxide structural layer 12, in a belt conveyer furnace similar to the above, the glass substrate with a silica film was heated at 540°C, and a nitrogen gas was used as a carrier gas, and tin tetrachloride, water and hydrogen chloride were used as a material gas for formation of the first oxide structural layer 12. By adjusting the concentration of tin tetrachloride being 0.1 vol% to the total gas amount of the carrier gas and the material gas, centers having a mass thickness of 5 nm were formed on the silica film. Then, by adjusting the concentration of tin tetrachloride being 0.9 vol% to the total gas amount, a first oxide structural layer 12 comprising ridges discretely formed with an average height of ridges of 620 nm, was formed. In this state, the first oxide structural layer 12 was measured by an AFM (atomic force microscope), whereupon ridges comprising tin oxide were discretely formed with a density of 0.4 ridge/µm² on average. Here, the mass thickness is a thickness assuming that the film was uniformly formed on the film-formation area, obtained by calculating the volume from the mass of the ridges comprising tin oxide. Further, the average height of the ridges was determined by measuring the cross-section with an electron microscope (SEM) after the transparent conductive film was prepared.

### (b) Formation of second oxide layer and conductive oxide layer

The glass substrate on which the first oxide structural layer 12 was formed was divided into 5 equal parts, one of them was heated at 550°C in a batch type electric furnace, and using a nitrogen gas as a carrier gas, tin tetrachloride as a material gas for forming an oxide of tin, and tetrachlorosilane as a material gas for forming silica, a second oxide layer 14 was formed on the first oxide structural layer 12. Such material gases were mixed with the nitrogen gas so that the total amount of tin tetrachloride and tetrachlorosilane became 0.1 vol%, and sprayed together with water vapor over the glass substrate on which the first oxide structural layer 12 was formed, thereby to form a film (second oxide layer 14) comprising a mixed oxide of tin and silicon. The surface composition of this film was analyzed by ESCA (electron spectroscopy for chemical analysis), whereupon the element ratio of tin to silicon was 0.5:0.5.

Further, on a glass substrate for evaluation of physical properties on which only a silica film was formed, a mixed oxide film of tin and silicon was formed under the same film formation conditions, and the thickness was measured by a feeler type thickness meter, whereupon it was 125 nm. That is, the thickness of the second oxide layer 14 was 125 nm. Further, the d-line refractive index of the mixed oxide film was measured by an ellipsometer, whereupon it was 1.75.

The glass substrate on which the first oxide structural layer 12 and the second oxide layer 14 were formed was heated again at 540°C in a belt conveyer furnace and simultaneously sprayed with tin tetrachloride, water and hydrogen fluoride by employing a conventional CVD method, to form a fluorine-doped tin oxide film (conductive oxide layer 16) thereby to obtain a transparent conductive film substrate 10.

The illuminant C transmittance and the haze of the prepared transparent conductive film substrate 10 were measured by a haze meter and as a result, they were 89.5% and 94.8%, respectively. Further, the prepared transparent conductive film substrate 10 was cut, the cut surface was observed by a SEM, angles of 10 dent portions such that the depth of a dent of the first oxide structural layer 12 was at least 20% of the average height of the first oxide structural layer were measured, and the average value A₁ was calculated, whereupon it was 103.1°. Further, angles of dent portions of the second oxide layer 14 on a region on the measured dent portions were measured, and the average value A₂ was calculated, whereupon it was 141.1 °. In this case, A₂/A₁=1.36.

### (c) Preparation of solar cell

In order to examine the performance of photoelectric conversion of a solar cell using the prepared transparent conductive film substrate 10, a part of the transparent conductive film substrate 10 was cut out, and a pin amorphous silicon film was formed thereon. An a-SiC:B layer (20 nm) as the p layer, an a-Si:H layer (350 nm) as the i layer and an a-Si:P layer (40 nm) as the n layer were formed in this order by a plasma CVD method using SiH₄/CH₄/H₂/B₂H₆, SiH₄/H₂, and SiH₄/H₂/PH₃ as materials, respectively. Then, Ga-doped ZnO was formed in a thickness of 20 nm, and an Al electrode was formed by a sputtering method to prepare a solar cell. The size of the solar cell portion is 5 mm square.

### (d) Method for evaluating properties of solar cell

The short circuit current, the open circuit voltage and the fill factor of the prepared solar cell were measured, and the photoelectric conversion efficiency was determined. For the measurement, a solar simulator (CE-24 model solar simulator manufactured by Opto Research Corporation) was used, and the irradiated light spectrum of the solar simulator at the time of IV measurement was adjusted so that AM (air mass) was 1.5, the light intensity was 100 (mW/cm²). As the electrode of the solar cell, one having an area of 6.25 (mm²) was used.

The relative value of the photoelectric conversion efficiency obtained by standardizing the measured photoelectric conversion efficiency of the solar cell by the efficiency in Comparative Example 1 (described hereinafter) wherein A₂/A₁ is approximately 1, is shown in Table 2 shown hereinafter.

### EXAMPLE 2

Using one of the five equally divided parts of the glass substrate on which the first oxide structural layer 12 was formed prepared in Example 1, a transparent conductive film substrate 10 was prepared in the same manner as in Example 1 by carrying out up to formation of the conductive oxide layer 16, except that the film formation time for the second oxide layer 14 was changed, and the thickness of the second oxide layer 14 was 50 nm. The illuminant C transmittance and the haze of the transparent conductive film substrate 10 were 89.5% and 87.5%, respectively.

Further, the prepared transparent conductive film substrate 10 was cut, its cut surface was observed by a SEM, angles of dent portions such that the depth of a dent of the first oxide structural layer 12 was at least 20% of the average height of the first oxide structural layer were measured, and the average value A₁ was calculated, whereupon it was 110.2°. Further, angles of dent portions of the second oxide layer 14 on a region on the measured dent portions were measured, and the average value A₂ was calculated, whereupon it was 138.1°. In this case, A₂/A₁=1.25.

Using this substrate, a solar cell was prepared in the same manner as in Example 1, and the photoelectric conversion performance was evaluated by the above method. The results are shown in Table 2.

### EXAMPLE 3

Using one of the five equally divided parts of the glass substrate on which the first oxide structural layer 12 was formed prepared in Example 1, a transparent conductive film substrate 10 was prepared in the same manner as in Example 1 by carrying out up to formation of the conductive oxide layer 16, except that the film formation time for the second oxide layer 14 was changed, and the thickness of the second oxide layer 14 was 200 nm. The illuminant C transmittance and the haze of the transparent conductive film substrate 10 were 88.6% and 96.0%, respectively. Further, the prepared transparent conductive film substrate 10 was cut, its cut surface was observed by a SEM, angles of dent portions such that the depth of a dent of the first oxide structural layer 12 was at least 20% of the average height of the first oxide structural layer were measured, and the average value A₁ was calculated, whereupon it was 111.7°. Further, angles of dent portions of the second oxide layer 14 on a region on the measured dent portions were measured, and the average value A₂ was calculated, whereupon it was 146.5°. In this case, A₂/A₁=1.31.

Using this substrate, a solar cell was prepared in the same manner as in Example 1, and the photoelectric conversion performance was evaluated by the above method. The results are shown in Table 2.

### COMPARATIVE EXAMPLE 1

Using one of the five equally divided parts of the glass substrate on which the first oxide structural layer 12 was formed prepared in Example 1, a silica film having a thickness of 15 nm as a second oxide layer was formed in the same method as disclosed in Patent Document 2 (JP-A-2005-347490). Then, on this substrate, a conductive film corresponding to the conductive oxide layer 16 was prepared in the same manner as in Example 1. The illuminant C transmittance and the haze of the prepared transparent conductive film substrate were 89.1 % and 86.2%, respectively, and it was confirmed that the haze is close to the upper limit of at most 90% which is the range of an effective haze disclosed in Patent Document 2. The d-line refractive index measured in the same manner as in Example 1 was 1.45. The prepared transparent conductive film substrate was cut, the cut surface was observed by a SEM, angles of dent portions such that the depth of a dent of the first oxide structural layer was at least 20% of the average height of the first oxide structural layer were measured, and the average value A₁ was calculated, whereupon it was 108.7°. Further, angles of dent portions of the second oxide layer 14 on a region on the measured dent portions were measured, and the average value A₂ was calculated, whereupon it was 110.1°. In this case, A₂/A₁=1.01. Using this substrate, a solar cell was prepared in the same manner as in Example 1, and the photoelectric conversion efficiency was measured by the above method, and based on the measured photoelectric conversion efficiency as a standard, other Examples and Comparative Examples were evaluated.

### COMPARATIVE EXAMPLE 2

By using one of the five equally divided parts of the glass substrate on which the first oxide structural layer 12 was formed prepared in Example 1, a second oxide layer was formed in the same apparatus as in Example 1. The temperature at the time of forming the layer, and tin tetrachloride and tetrachlorosilane as materials used, were the same as in Example 1, but the mixing ratio of the material gases was changed from Example 1 to prepare a second oxide layer having a tin:silicon ratio different from Example 1.

On a glass substrate for evaluation of physical properties on which only silica was formed in the same manner as in Example 1, this film was formed at the same time, and the surface composition was measured by ESCA, whereupon Sn:Si=0.8:0.2. Further, the film thickness was measured by a feeler type thickness meter in the same manner as in Example 1, whereupon it was 100 (nm). Further, the d-line refractive index measured in the same manner as in Example 1 was 1.98.

The illuminant C transmittance and the haze of the prepared transparent conductive film substrate were 79.2% and 95.5%, respectively. Further, the prepared transparent conductive film substrate was cut, the cut surface was observed by a SEM, angles of dent portions such that the depth of a dent of the first oxide structural layer was at least 20% of the average height of the first oxide structural layer were measured, and the average value A₁ was calculated, whereupon it was 110.6°. Further, angles of dent portions of the second oxide layer 14 on a region on the measured dent portions were measured, and the average value A₂ was calculated, whereupon it was 100.1°. In this case, A₂/A₁=0.9.

Using this substrate, a solar cell was prepared in the same manner as in Example 1, and the photoelectric conversion performance was evaluated by the above method. The results are shown in Table 2.

In Tables 1 and 2, the composition and the physical properties of the second oxide layer, the results of evaluation of the performance of the solar cell, and the like in Examples 1 to 3 and Comparative Examples 1 and 2 are shown.

In Table 1, x in SnSiOx represents 1.95 to 2.45.

The illuminant C transmittance of the transparent conductive film substrate in Comparative Example 2 is lower by at least 10% as compared with Examples 1 to 3 and Comparative Example 1. This is considered to be because the refractive index of the second oxide layer was high, and accordingly the reflection was increased, and thus the light which entered the solar cell portion was decreased. Further, it was observed that the second oxide layer grew as crystal grains as a result of an increase of the tin concentration in the second oxide layer, and as a result, A₂/A₁ was 0.9, and the second oxide layer formed a steep roughness shape. As a result, the photoelectric conversion efficiency was at most half as compared with Comparative Example 1.

The values of A₂/A₁ and the measured photoelectric conversion efficiencies of the solar cells are shown in Table 2 and Fig. 4.

**TABLE 1**

| | Physical properties of second oxide layer | | | |
|---|---|---|---|---|
| | Film material | Compositional ratio | Film thickness | Refractive index |
| | | Sn:Si | nm | |
| Ex.1 | SnSiOₓ | 50:50 | 125 | 1.75 |
| Ex. 2 | SnSiOₓ | 50:50 | 50 | 1.75 |
| Ex. 3 | SnSiOₓ | 50:50 | 200 | 1.75 |
| Comp. Ex. 1 | SiO₂ | 0:100 | 15 | 1.45 |
| Comp. Ex. 2 | SnSiOₓ | 80:20 | 100 | 1.98 |

**TABLE 2**

| | Illuminant C transmittance | Haze | A₂/A₁ | Relative value of photoelectric conversion efficiency |
|---|---|---|---|---|
| | (%) | (%) | | |
| Ex. 1 | 89.5 | 94.8 | 1.36 | 1.52 |
| Ex. 2 | 89.5 | 87.5 | 1.25 | 1.64 |
| Ex. 3 | 88.6 | 96.0 | 1.31 | 1.61 |
| Comp. Ex. 1 | 89.1 | 86.2 | 1.01 | 1.00 |
| Comp. Ex. 2 | 79.2 | 95.5 | 0.90 | 0.49 |

In Example 1, the photoelectric conversion efficiency was increased to 1.52 times as compared with Comparative Example 1, and the illuminant C transmittance was increased by 0.4%, and the effect of the second oxide layer 14 can be confirmed.

In Example 2, the photoelectric conversion efficiency was increased to 1.64 times as compared with Comparative Example 1, and the illuminant C transmittance was increased by 0.4%, and the effect of the second oxide layer 14 can be confirmed.

In Example 3, the photoelectric conversion efficiency was increased to 1.61 times as compared with Comparative Example 1, but the illuminant C transmittance was decreased by 0.5%. The decrease in the transmittance is considered to be an increase in light absorption as the second oxide layer 14 became thick. However, the effect by making the steep roughness shape gentle is higher as compared with the decrease in the light transmittance and as a result, the photoelectric conversion efficiency was remarkably improved, and the effect of the second oxide layer can be confirmed.

As shown in Fig. 4, it is confirmed that the increase in the photoelectric conversion efficiency is effective when A₂/A₁ is at least 1.1.

### EXAMPLE 4

In the same manner as in Example 1, a glass substrate on which a first oxide structural layer 12 comprising tin oxide particles having a height of 750 nm and an average density of 0.7 particle/µm² was formed was prepared by adjusting the ratio of tin tetrachloride, water and hydrogen chloride as material gases, and the glass substrate was cut into two. Using one of these two equally divided parts, using dichlorosilane and tin tetrachloride as materials for formation of the second oxide layer 14, the heated glass while being moved at a rate of 3 m per minute, was sprayed with the materials to form a second oxide layer 14 having a thickness of 70 nm. The composition, the physical properties and the like of the second oxide layer are shown in Table 3. Then, in the same manner as in Example 1, a transparent conductive film substrate 10 was prepared by carrying out up to formation of the conductive oxide layer 16. The illuminant C transmittance and the haze of the transparent conductive film substrate 10 were 87.9% and 90.7%, respectively. Further, the prepared transparent conductive film substrate 10 was cut, the cut surface was observed by a SEM, angles of dent portions such that the depth of a dent of the first oxide structural layer 12 was at least 20% of the average height of the first oxide structural layer were measured, and the average value A₁ was calculated, whereupon it was 109.5°. Further, angles of dent portions of the second oxide layer 14 on a region on the measured dent portions were measured, and the average value A₂ was calculated, whereupon it was 140.2°. In this case, A₂/A₁=1.28.

Using this substrate, a solar cell was prepared in the same manner as in Example 1. In this Example, in order to further increase the cell efficiency, an a-Si:H (hydrogen-doped a-Si) layer was formed in a thickness of 400 nm as the i layer, and the photoelectric conversion performance was evaluated by the above method. The photoelectric conversion efficiency in this Example was compared with that in Comparative Example 3 wherein the same substrate up to the first oxide structural layer 12 was used but the thickness of the i layer was 400 nm. The results are shown in Table 3.

### COMPARATIVE EXAMPLE 3

Using one of the five equally divided parts of the glass substrate on which the first oxide structural layer 12 was formed prepared in Example 4, a silica film having a thickness of 15 nm as a second oxide layer was formed in the same method as disclosed in Patent Document 2 (JP-A-2005-347490). Then, on this substrate, a conductive film corresponding to the conductive oxide layer 16 was prepared in the same manner as in Example 1. The illuminant C transmittance and the haze of the prepared transparent conductive film substrate were 88.0% and 88.5%, respectively, and it was confirmed that the haze is close to the upper limit of at most 90% which is the range of an effective haze disclosed in Patent Document 2. The d-line refractive index measured in the same manner as in Example 1 was 1.45. The prepared transparent conductive film substrate was cut, the cut surface was observed by a SEM, angles of dent portions such that the depth of a dent of the first oxide structural layer was at least 20% of the average height of the first oxide structural layer were measured, and the average value A₁ was calculated, whereupon it was 110.8°. Further, angles of dent portions of the second oxide layer on a region on the measured dent portions were measured, and the average value A₂ was calculated, whereupon it was 115.0°. In this case, A₂/A₁=1.04. Using this substrate, in the same manner as in Example 4, a solar cell was prepared wherein an a-Si:H (hydrogen-doped a-Si) (hydrogen-doped a-Si) layer was formed in a thickness of 400 nm as the i layer, and the photoelectric conversion performance was evaluated by the above method. In this Comparative Example, the photoelectric conversion performance was 1.61 times as compared with Comparative Example 1, and the photoelectric conversion efficiency was increased by the effect of making the i layer thick.

### EXAMPLE 5

In the same manner as in Example 1, a glass substrate on which a first oxide structural layer 12 comprising tin oxide particles having a height of 700 nm and an average density of 0.7 particle/µm² was formed was prepared by adjusting the ratio of tin tetrachloride, water and hydrogen chloride as material gases, and the glass substrate was cut into four. Using one of these four equally divided parts, using trichlorosilane and tin tetrachloride as materials for formation of the second oxide layer 14, the heated glass while being moved at a rate of 3 m per minute, was sprayed with the materials to form a second oxide layer 14 having a thickness of 80 nm. The composition, the physical properties and the like of the second oxide layer are shown in Table 3. Then, in the same manner as in Example 1, a transparent conductive film substrate 10 was prepared by carrying out up to formation of the conductive oxide layer 16. The illuminant C transmittance and the haze of the transparent conductive film substrate 10 were 79.3% and 89.8%, respectively. Further, the prepared transparent conductive film substrate 10 was cut, the cut surface was observed by a SEM, angles of dent portions such that the depth of a dent of the first oxide structural layer 12 was at least 20% of the average height of the first oxide structural layer were measured, and the average value A₁ was calculated, whereupon it was 101.2°. Further, angles of dent portions of the second oxide layer 14 on a region on the measured dent portions were measured, and the average value A₂ was calculated, whereupon it was 138.1°. In this case, A₂/A₁=1.36.

Using this substrate, in the same manner as in Example 4, a solar cell was prepared wherein an a-Si:H (hydrogen-doped a-Si) (hydrogen-doped a-Si) layer was formed in a thickness of 400 nm as the i layer, and the photoelectric conversion performance was evaluated by the above method. The photoelectric conversion efficiency in this Example was compared with that in Comparative Example 4 wherein the same substrate up to the first oxide structural layer 12 was used but the thickness of the i layer was 400 nm. The results are shown in Table 4.

### EXAMPLE 6

Using one of the four equally divided parts of the glass substrate on which the first oxide structural layer 12 was formed prepared in Example 5, using trichlorosilane and tin tetrachloride as materials for formation of the second oxide layer 14, the heated glass while being moved at a rate of 3 m per minute, was sprayed with the materials to form a second oxide layer 14 having a thickness of 30 nm. The composition, the physical properties and the like of the second oxide layer are shown in Table 3. In this Example, the amount of supply of trichlorosilane was 1.3 times and the amount of supply of tin tetrachloride was 1.0 time as compared with Example 5. Then, in the same manner as in Example 1, a transparent conductive film substrate 10 was prepared by carrying out up to formation of the conductive oxide layer 16. The illuminant C transmittance and the haze of this transparent conductive film substrate 10 were 81.5% and 81.6%, respectively. Further, the prepared transparent conductive film substrate 10 was cut, the cut surface was observed by a SEM, angles of dent portions such that the depth of a dent of the first oxide structural layer 12 was at least 20% of the average height of the first oxide structural layer were measured, and the average value A₁ was calculated, whereupon it was 103.2°. Further, angles of dent portions of the second oxide layer 14 on a region on the measured dent portions were measured, and the average value A₂ was calculated, whereupon it was 143.1°. In this case, A₂/A₁=1.12.

Using this substrate, in the same manner as in Example 4, a solar cell was prepared wherein an a-Si:H (hydrogen-doped a-Si) (hydrogen-doped a-Si) layer was formed in a thickness of 400 nm as the i layer, and the photoelectric conversion performance was evaluated by the above method. The photoelectric conversion efficiency in this Example was compared with that in Comparative Example 4 wherein the same substrate up to the first oxide structural layer 12 was used but the thickness of the i layer was 400 nm. The results are shown in Table 4.

### EXAMPLE 7

Using one of the four equally divided parts of the glass substrate on which the first oxide structural layer 12 was formed prepared in Example 5, using tetraethoxysilane and titanium tetraisopropoxide as materials for formation of the second oxide layer 14, the heated glass while being moved at a rate of 1 m per minute, was sprayed with the materials to form a second oxide layer 14 having a thickness of 60 nm. The composition, the physical properties and the like of the second oxide layer are shown in Table 3. Then, in the same manner as in Example 1, a transparent conductive film substrate 10 was prepared by carrying out up to formation of the conductive oxide layer 16. The illuminant C transmittance and the haze of this transparent conductive film substrate 10 were 81.0% and 91.2%, respectively. Further, the prepared transparent conductive film substrate 10 was cut, the cut surface was observed by a SEM, angles of dent portions such that the depth of a dent of the first oxide structural layer 12 was at least 20% of the average height of the first oxide structural layer were measured, and the average value A₁ was calculated, whereupon it was 105.4°. Further, angles of dent portions of the second oxide layer 14 on a region on the measured dent portions were measured, and the average value A₂ was calculated, whereupon it was 118.2°. In this case, A₂/A₁=1.21.

Using this substrate, in the same manner as in Example 4, a solar cell was prepared wherein an a-Si:H (hydrogen-doped a-Si) layer was formed in a thickness of 400 nm as the i layer, and the photoelectric conversion performance was evaluated by the above method. The photoelectric conversion efficiency in this Example was compared with that in Comparative Example 4 wherein the same substrate up to the first oxide structural layer 12 was used but the thickness of the i layer was 400 nm. The results are shown in Table 4.

### COMPARATIVE EXAMPLE 4

Using one of the four equally divided parts of the glass substrate on which the first oxide structural layer 12 was formed prepared in Example 5, a silica film having a thickness of 15 nm as a second oxide layer was formed in the same method as disclosed in Patent Document 2 (JP-A-2005-347490). The composition, the physical properties and the like of the second oxide layer are shown in Table 3. Then, on this substrate, a conductive film corresponding to the conductive oxide layer 16 was prepared in the same manner as in Example 1. The illuminant C transmittance and the haze of the prepared transparent conductive film substrate were 79.0% and 85.0%, respectively, and it was confirmed that the haze is close to the upper limit of at most 90% which is the range of an effective haze disclosed in Patent Document 2. The d-line refractive index measured in the same manner as in Example 1 was 1.45. The prepared transparent conductive film substrate was cut, the cut surface was observed by a SEM, angles of dent portions such that the depth of a dent of the first oxide structural layer was at least 20% of the average height of the first oxide structural layer were measured, and the average value A₁ was calculated, whereupon it was 104.8°. Further, angles of dent portions of the second oxide layer 14 on a region on the measured dent portions were measured, and the average value A₂ was calculated, whereupon it was 108.4°. In this case, A₂/A₁=1.03. Using this substrate, in the same manner as in Example 4, a solar cell was prepared wherein an a-Si:H (hydrogen-doped a-Si) layer was formed in a thickness of 400 nm as the i layer, and the photoelectric conversion performance was evaluated by the above method. The photoelectric conversion efficiency of the prepared cell was 1.49 times as compared with Comparative Example 1.

In Examples 5 to 7 and Comparative Examples 3 and 4, the influence of defects considered to occur mainly at the time of formation of the i layer is reduced, and the difference in the cell efficiency is small, since the thickness of the i layer used was thick as compared with Examples 1 to 4 and Comparative Examples 1 and 2. That is, even in a case where the structure of a cell is changed to prepare a higher performance cell, by preparing a transparent conductive film wherein A₂/A₁ is at least 1.1 as in the present invention, it is possible to increase the photoelectric conversion performance.

### EXAMPLE 8

In the same manner as in Example 1, a glass substrate on which a first oxide structural layer 12 comprising tin oxide particles having a height of 700 nm and an average density of 0.6 particle/µm² was formed was prepared by adjusting the ratio of tin tetrachloride, water and hydrogen chloride as material gases, and the glass substrate was cut into two. Using one of the two equally divided parts, using trichlorosilane and tin tetrachloride as materials for formation of the second oxide layer 14, the heated glass while being moved at a rate of 3 m per minute, was sprayed with the materials to form a second oxide layer 14 having a thickness of 70 nm. The composition, the physical properties and the like of the second oxide layer are shown in Table 3. Then, in the same manner as in Example 1, a transparent conductive film substrate 10 was prepared by carrying out up to formation of the conductive oxide layer 16. The illuminant C transmittance and the haze of the transparent conductive film substrate 10 were 77.6% and 93.1 %, respectively. Further, the prepared transparent conductive film substrate 10 was cut, the cut surface was observed by a SEM, angles of dent portions such that the depth of a dent of the first oxide structural layer 12 was at least 20% of the average height of the first oxide structural layer were measured, and the average value A₁ was calculated, whereupon it was 79.0°. Further, angles of dent portions of the second oxide layer 14 on a region on the measured dent portions were measured, and the average value A₂ was calculated, whereupon it was 127.0°. In this case, A₂/A₁=1.61.

In order to examine the photoelectric conversion performance of a solar cell using the prepared transparent conductive film substrate 10, a part of the transparent conductive film substrate 10 was cut out, and a pin amorphous silicon-microcrystalline silicon tandem solar cell was formed thereon. With respect to the amorphous silicon film, an a-SiC:B (boron-doped) layer (20 nm) as the p layer, an a-Si:H (hydrogen-doped a-Si a-SiC) layer (150 nm) as the i layer, and a microcrystalline-Si:P (phosphorus-doped microcrystalline Si) layer (40 nm) as the n layer were formed in this order by a plasma CVD method. Then, with respect to the microcrystalline silicon film, a microcrystalline Si:H:B (hydrogen and boron-doped microcrystalline Si) layer (30 nm) as the microcrystalline silicon film, a microcrystalline-Si:H (hydrogen-doped microcrystalline Si) layer (1.5 µm) as the i layer and a microcrystalline-Si:H:P (hydrogen and phosphorus-doped microcrystalline Si) layer (40 nm) as the n layer were formed in this order by a plasma CVD method. Then, Ga-doped ZnO was formed in a thickness of 20 nm, and an Al electrode was formed by a sputtering method to prepare a solar cell. The size of the solar cell portion was 5 mm square.

The photoelectric conversion efficiency of the prepared tandem solar cell was improved by at least 15% as compared with the efficiency of the amorphous solar cell in each of Examples 1 to 7. Further, since the effect of the second oxide layer cannot simply be compared with an amorphous solar cell, the cell efficiency was compared with that in Comparative Example 5 wherein a tandem solar cell was prepared by changing only the second oxide layer. As a result, it is confirmed that the photoelectric conversion efficiency was improved by 4%.

Further, the prepared tandem solar cell was cut by ion beam, and the cut surface was observed by an electron microscope, whereupon one space considered to be a defect of silicon was confirmed in a cut surface with a length of 40 µm. The tandem solar cell prepared in Comparative Example 5 was measured in the same manner, whereupon 8 spaces considered to be defects of silicon were confirmed in a cut surface with a length of 40 µm. The above improvement in the photoelectric conversion efficiency is considered to be attributable to a decrease in such silicon defects.

### COMPARATIVE EXAMPLE 5

Using one of the two equally divided parts of the glass substrate on which the first oxide structural layer 12 was formed prepared in Example 8, a silica film having a thickness of 15 nm as a second oxide layer was formed in the same method as disclosed in Patent Document 2 (JP-A-2005-347490). The composition, the physical properties and the like of the second oxide layer are shown in Table 3. Then, on this substrate, a conductive film corresponding to the conductive oxide layer 16 was prepared in the same manner as in Example 1. The illuminant C transmittance and the haze of the prepared transparent conductive film substrate were 76.3% and 93.1 %, respectively, and it was confirmed that the haze is close to the upper limit of at most 90% which is the range of an effective haze disclosed in Patent Document 2. The d-line refractive index measured in the same manner as in Example 1 was 1.45. The prepared transparent conductive film substrate was cut, the cut surface was observed by a SEM, angles of dent portions such that the depth of a dent of the first oxide structural layer was at least 20% of the average height of the first oxide structural layer were measured, and the average value A₁ was calculated, whereupon it was 85.0°. Further, angles of dent portions of the second oxide layer 14 on a region on the measured dent portions were measured, and the average value A₂ was calculated, whereupon it was 89.1°. In this case, A₂/A₁=1.05. Using this substrate, a tandem solar cell in the same manner as in Example 8 was prepared.

### EXAMPLE 9

In the same manner as in Example 1, a glass substrate on which a first oxide structural layer 12 comprising tin oxide particles having a height of 600 nm and an average density of 0.8 particle/µm² was formed was prepared by adjusting the ratio of tin tetrachloride, water and hydrogen chloride as material gases, and the glass substrate was cut into two. Using one of these two equally divided parts, using trichlorosilane and tin tetrachloride as materials for formation of the second oxide layer 14, the heated glass while being moved at a rate of 3 m per minute, was sprayed with the materials to form a second oxide layer 14 having a thickness of 70 nm. The composition, the physical properties and the like of the second oxide layer are shown in Table 3. Then, in the same manner as in Example 1, a transparent conductive film substrate 10 was prepared by carrying out up to formation of the conductive oxide layer 16. The illuminant C transmittance and the haze of the transparent conductive film substrate 10 were 82.0% and 94.1 %, respectively. Further, the prepared transparent conductive film substrate 10 was cut, the cut surface was observed by a SEM, angles of dent portions such that the depth of a dent of the first oxide structural layer 12 was at least 20% of the average height of the first oxide structural layer were measured, and the average value A₁ was calculated, whereupon it was 84.0°. Further, angles of dent portions of the second oxide layer 14 on a region on the measured dent portions were measured, and the average value A₂ was calculated, whereupon it was 147.0°. In this case, A₂/A₁=1.74.

In order to examine the photoelectric conversion performance of a solar cell using the prepared transparent conductive film substrate 10, a part of the transparent conductive film substrate 10 was cut out, and a tandem solar cell in the same manner as in Example 8 was prepared.

The cell efficiency was compared with Comparative Example 6 wherein a tandem solar cell was prepared by changing only the second oxide layer, and it was confirmed that the photoelectric conversion efficiency in this Example was improved by 3%. The results are shown in Table 4.

### COMPARATIVE EXAMPLE 6

Using one of the two equally divided parts of the glass substrate on which the first oxide structural layer 12 was formed prepared in Example 9, a silica film having a thickness of 15 nm as a second oxide layer was formed in the same method as disclosed in Patent Document 2 (JP-A-2005-347490). The composition, the physical properties and the like of the second oxide layer are shown in Table 3. Then, on this substrate, a conductive film corresponding to the conductive oxide layer 16 was prepared in the same manner as in Example 1. The illuminant C transmittance and the haze of the prepared transparent conductive film substrate were 81.0% and 92.8%, respectively, and it was confirmed that the haze is close to the upper limit of at most 90% which is the range of an effective haze disclosed in Patent Document 2. The d-line refractive index measured in the same manner as in Example 1 was 1.45. The prepared transparent conductive film substrate was cut, the cut surface was observed by a SEM, angles of dent portions such that the depth of a dent of the first oxide structural layer was at least 20% of the average height of the first oxide structural layer were measured, and the average value A₁ was calculated, whereupon it was 91.2°. Further, angles of dent portions of the second oxide layer 14 on a region on the measured dent portions were measured, and the average value A₂ was calculated, whereupon it was 94.8°. In this case, A₂/A₁=1.04. Using this substrate, a tandem solar cell in the same manner as in Example 8 was prepared. The results are shown in Table 4.

### EXAMPLES 10 to 12

In the same manner as in Example 1, two glass substrates on which a first oxide structural layer 12 comprising tin oxide particles having a height of 750 nm and an average density of 0.6 particle/µm² was formed, were prepared by adjusting the ratio of tin tetrachloride, water and hydrogen chloride as material gases, and they were respectively cut into two parts. Using three among such four parts which were equally divided, using dichlorosilane and tin tetrachloride as materials for formation of the second oxide layer 14, each heated glass while being moved at a rate of 3 m per minute, was sprayed with the materials to form second oxide layers 14 having thicknesses of 40 nm, 50 nm and 70 nm, respectively. The composition and the like of the second oxide layer are shown in Table 3. Then, in the same manner as in Example 1, transparent conductive film substrates 10 were prepared by carrying out up to formation of the conductive oxide layer 16. The physical properties of the prepared substrates are shown in Table 3. A₂/A₁ of such substrates were measured, whereupon they were 1.32 to 1.37.

Using these substrates, solar cells were prepared in the same manner as in Example 4. The photoelectric conversion efficiencies in Examples 10 to 12 were compared with Comparative Example 7 wherein the same substrate up to the first oxide structural layer 12 was used but the thickness of the i layer was 400 nm. The results are shown in Table 4.

### COMPARATIVE EXAMPLE 7

Using one of the four parts of the glass substrates on which the first oxide structural layer 12 was formed prepared in Examples 10 to 12, a silica film having a thickness of 15 nm as a second oxide layer was prepared in the same method as disclosed in Patent Document 2 (JP-A-2005-347490). The composition, the physical properties and the like of the second oxide layer are shown in Table 3. Then, on this substrate, a conductive film corresponding to the conductive oxide layer 16 was prepared in the same manner as in Example 1. The illuminant C transmittance and the haze of the prepared transparent conductive film substrate were 88.5% and 88.0%, respectively, and it was confirmed that they are close to the upper limit of at most 90% which is the range of an effective haze disclosed in Patent Document 2. The d-line refractive index measured in the same manner as in Example 1 was 1.45. The prepared transparent conductive film substrate was cut, the cut surface was observed by an SEM, and A₂/A₁ was calculated, whereupon it was 1.01. Using this substrate, in the same manner as in Examples 10 to 12, a solar cell was prepared wherein an a-Si:H (hydrogen-doped a-Si) layer was formed in a thickness of 400 nm as the i layer. The results of evaluation of the solar cell are shown in Table 4.

In Tables 3 and 4, the composition, and the physical properties of the second oxide layer, the results of evaluation of the performance of the solar cells, and the like in Examples 4 to 12 and Comparative Examples 3 to 7 are shown.

In Table 3, x in SnSiOx and TiSiOx represents from 2.0 to 2.3.

**TABLE 3**

| | Physical properties of second oxide layer | | | |
|---|---|---|---|---|
| | Film material | Compositional ratio | Film thickness | Refractive index |
| | | M:Sn (M;Sn,Ti) | nm | |
| Ex. 4 | SnSiOx | 40:60 | 70 | 1.65 |
| Comp. Ex. 3 | SiO₂ | 0:100 | 15 | 1.45 |
| Ex. 5 | SnSiOx | 65:35 | 80 | 1.8 |
| Ex. 6 | SnSiOx | 50:50 | 30 | 1.7 |
| Ex. 7 | TiSiOx | 40:60 | 60 | 1.87 |
| Comp. Ex. 4 | SiO₂ | 0:100 | 15 | 1.45 |
| Ex. 8 | SnSiOx | 45:55 | 70 | 1.7 |
| Comp. Ex. 5 | SiO₂ | 0:100 | 15 | 1.45 |
| Ex. 9 | SnSiOx | 45:55 | 70 | 1.7 |
| Comp. Ex. 6 | SiO₂ | 0:100 | 15 | 1.45 |
| Ex. 10 | SnSiOx | 50:50 | 40 | 1.7 |
| Ex. 11 | SnSiOx | 50:50 | 50 | 1.7 |
| Ex. 12 | SnSiOx | 50:50 | 70 | 1.7 |
| Comp. Ex. 7 | SiO₂ | 0:100 | 15 | 1.45 |

**TABLE 4**

| | Illuminant C transmittance | Haze | A₂/A₁ | Relative value of photoelectric conversion efficiency | |
|---|---|---|---|---|---|
| | (%) | (%) | | | |
| Ex. 4 | 87.9 | 90.7 | 1.28 | 1.05 | Based on Comparative Example 3 |
| Comp. Ex. 3 | 88.0 | 88.5 | 1.04 | 1 | |
| Ex. 5 | 79.3 | 89.8 | 1.36 | 1.01 | Based on Comparative Example 4 |
| Ex. 6 | 81.5 | 81.6 | 1.12 | 1.03 | |
| Ex. 7 | 81.0 | 91.2 | 1.21 | 1.02 | |
| Comp. Ex. 4 | 79.0 | 85.0 | 1.03 | 1 | |
| Ex. 8 | 77.6 | 93.1 | 1.61 | 1.04 | Based on Comparative Example 5 |
| Comp. Ex. 5 | 76.3 | 93.1 | 1.05 | 1 | |
| Ex. 9 | 82.0 | 94.1 | 1.74 | 1.03 | Based on Comparative Example 6 |
| Comp. Ex. 6 | 81 | 92.8 | 1.04 | 1 | |
| Ex. 10 | 88.8 | 89.0 | 1.32 | 1.03 | Based on Comparative Example 7 |
| Ex. 11 | 88.4 | 89.2 | 1.32 | 1.04 | |
| Ex. 12 | 87.9 | 90.7 | 1.37 | 1.05 | |
| Comp. Ex. 7 | 88.5 | 88.0 | 1.01 | 1 | |

Further, in a case where the material of the second oxide layer is an oxide of Si and Sn, and a conductive film (conductive oxide layer) comprising tin oxide was formed thereon, the ratio of intensity of (200) to (110) obtained by measuring the X-ray diffraction intensity of tin oxide, is preferably at least 1.10 from the viewpoint of the photoelectric conversion efficiency.

The reason why the photoelectric conversion efficiency changes when the material of the second oxide layer is an oxide of Si and Sn, is not clearly understood, but is considered as follows taking tin oxide formed on the second oxide layer as an Example.

The type and the thickness of the second oxide layer were changed, and under the same conditions except for them, tin oxide was formed as a conductive film on the second oxide layer, and a solar cell was formed under the same conditions, and the photoelectric conversion efficiency of the solar cell was compared. Further, a part of each substrate on which up to tin oxide was formed in each of Examples 10 to 12 and Comparative Example 7 was cut out, and the X-ray diffraction intensity was measured, and the ratio of intensity of (200) to (110) of tin oxide crystals was compared. The results are shown in Table 5.

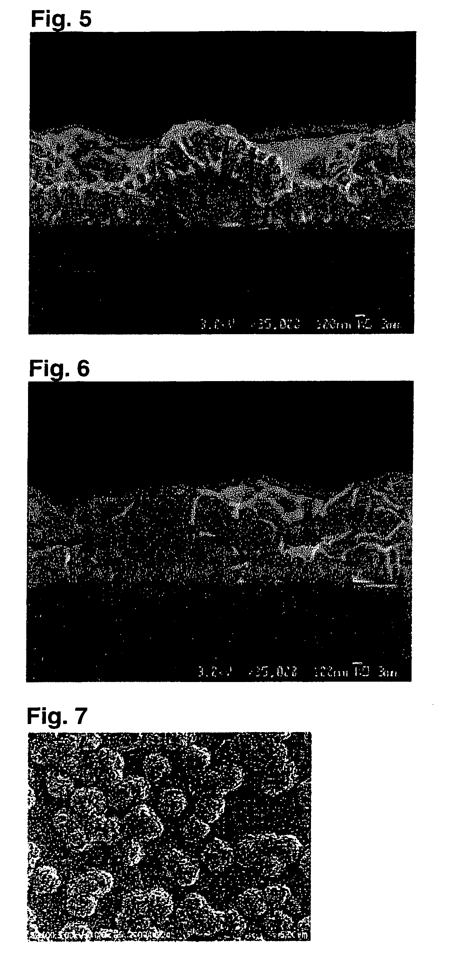

In Comparative Example 7, the ratio of (200)/(110) was 0.98. The SEM image of the cross-section is shown in Fig. 6. In Examples 10 to 12, the ratio of (200)/(110) was from 1.15 to 1.29. The cross-sectional SEM image of Example is shown in Fig. 5. In the image with good photoelectric conversion efficiency (Examples 10 to 12), crystallites of tin oxide (conductive oxide layer) in a radial form are confirmed on dent portions of the first oxide structural layer via the second oxide layer. That is, since the crystallites radially expand, the crystallites are aligned in (200), and with respect to the ratio of X-ray diffraction intensity, (200)/(110) is from 1.15 to 1.29, and the crystallites are likely to align in (200). In Comparative Example 7, crystallites of tin oxide on the first oxide structural layer via the second oxide layer are randomly formed, whereby the ratio of X-ray diffraction intensity was so low as 0.98, and the (200) alignment of tin oxide is poor on the average. The surface of well aligned tin oxide comprise crystallites with same alignment, and have a relatively uniform shape. The SEM image of the surface in such a case is shown in Fig. 7. Whereas, on the surface of poor aligned tin oxide, with a ratio of X-ray diffraction intensity of 0.98, the crystallites were randomly disposed and as a results, it is considered that the roughness on the outermost layer tends to be non-uniform. The conductive oxide layer laminated on the non-uniform roughness tends to have a large number of silicon defects as disclosed in Example 8 and Comparative Example 5 and as a result, the photoelectric conversion efficiency is considered to be decreased.

**TABLE 5**

| X-ray intensity ratio | (200)/(110) |
|---|---|
| Ex. 10 | 1.22 |
| Ex. 11 | 1.15 |
| Ex. 12 | 1.29 |
| Comp. Ex. 7 | 0.97 |

The transparent conductive film substrate of the present invention and the solar cell using it were described in detail above. However, it should be understood that the present invention is not limited to the above embodiments and Examples, and various changes and modification are possible without departing from the intension and the scope of the present invention.

### INDUSTRIAL APPLICABILITY

The transparent conductive film substrate of the present invention is industrially useful since it can be used for preparation of a solar cell having improved photoelectric conversion performance as compared with conventional one as a substrate which is less likely to lead to a leak of an electric current by the concentration of an electric field, which is less likely to lead to deterioration of the photoelectric conversion performance, and which has a high light transmittance.

The entire disclosure of Japanese Patent Application No. 2008-201858 filed on August 5, 2008 including specification, claims, drawings and summary is incorporated herein by reference in its entirety.

### MEANINGS OF SYMBOLS

### EXPLANATION OF NUMERALS

- 10:: Transparent conductive film substrate
- 12:: First oxide structural layer
- 14:: Second oxide layer
- 16:: Conductive oxide layer
- 18:: Glass substrate
- 20:: Dept of dent
- 22:: Average height
- 24, 26:: Angle of dent portion

## Claims

1. A transparent conductive film substrate for a photoelectric conversion device, comprising a first oxide structural layer, a second oxide layer and a conductive oxide layer formed in this order on a glass substrate, wherein on the first oxide structural layer, a plurality of ridges protruding from the surface of the glass substrate are provided, and the height of the ridges from the surface of the glass substrate is at least 200 nm and at most 2,000 nm; and where the average value of angles of dent portions such that the depth of a dent between adjacent ridges among the plurality of the ridges is at least 20% of the average height of the first oxide structural layer, is A₁, and the average value of angles of dent portions of the second oxide layer formed on a region on the dent portions, is A₂, A₂/A₁ is at least 1.1.

2. The transparent conductive film substrate according to Claim 1, wherein A₂/A₁ is at least 1.2.

3. The transparent conductive film substrate according to Claim 1 or 2, wherein the haze as measured by illuminant C is at least 50%.

4. The transparent conductive film substrate according to any one of Claims 1 to 3, wherein the haze as measured by illuminant C is at least 85%.

5. The transparent conductive film substrate according to any one of Claims 1 to 4, wherein the first oxide structural layer comprises tin oxide.

6. The transparent conductive film substrate according to any one of Claims 1 to 5, wherein the second oxide layer is formed by an oxide layer having a refractive index of from 1.58 to 1.9.

7. The transparent conductive film substrate according to any one of Claims 1 to 6, wherein the second oxide layer comprises a mixed oxide of silicon and tin or a mixed oxide of silicon and titanium.

8. The transparent conductive film substrate according to Claim 7, wherein the second oxide layer comprises a mixed oxide of silicon and tin, and the molar ratio of tin to silicon of the mixed oxide is from 0.25:0.75 to 0.7:0.3.

9. The transparent conductive film substrate according to Claim 8, wherein the molar ratio of tin to silicon of the mixed oxide is from 0.4:0.6 to 0.6:0.4.

10. The transparent conductive film substrate according to any one of Claims 1 to 9, wherein the conductive oxide layer comprises tin oxide containing fluorine.

11. A solar cell prepared by using the transparent conductive film substrate as define in any one of Claims 1 to 10.
